# EUROPEAN PATENT APPLICATION

(11) **EP 4 418 489 A2**
(43) Date of publication of application: **21.08.2024**
(21) Application number: 23211643.4
(22) Date of filing: 23.11.2023
(51) Int. Cl.: H02J 7/00, G01R 31/50

(54) **CHARGING-DISCHARGING SYSTEM AND METHOD FOR DIAGNOSING FAULTY WIRING FOR THE SAME**

(30) Priority: 16.02.2023 CN 202310150504
(71) Applicant: Sungrow Energy Storage Technology Co., Ltd., Hefei, Anhui 230088 (CN)
(72) Inventor: LIANG, Dongyu, Hefei, Anhui (CN); DONG, Wengong, Hefei, Anhui (CN); LI, Qing, Hefei, Anhui (CN); HAN, Chen, Hefei, Anhui (CN); CHEN, Qiangdong, Hefei, Anhui (CN); LI, Xuteng, Hefei, Anhui (CN)
(74) Representative: Zacco Norway AS

(57) **Abstract**

A charging-discharging system and a method for diagnosing faulty wiring for the charging-discharging system are provided. If there is no faulty wiring between charging-discharging devices and corresponding sub-interfaces of a combiner box, a voltage across a master switch of each charging-discharging device is approximately zero after the charging-discharging devices are all powered on and the master switch in one of the charging-discharging devices is on. That is, an absolute value of the voltage across the master switch is less than or equal to a first preset voltage. Therefore, where there is a master switch whose voltage has the absolute value greater than the first preset voltage, there is faulty wiring between the charging-discharging device where the master switch is arranged and the corresponding sub-interface of the combiner box. That is, there is faulty wiring between the charging-discharging system and the combiner box.

## Description

### FIELD

The present disclosure relates to the technical field of power electronics, and in particular to a charging-discharging system and a method for diagnosing faulty wiring for the charging-discharging system.

### BACKGROUND

Conventionally, a household energy storage system includes multiple battery systems connected in parallel though a combiner box. The combiner box is subjected to mistake-proofing to prevent its positive and negative terminals from being connected in error.

However, the existing household energy storage system, after powered on, fails to diagnose faulty wiring between the combiner box and itself, resulting in safety hazards.

Therefore, it is an urgent need for the household energy storage system to diagnose faulty wiring between the combiner box and itself.

### SUMMARY

In view of the above, a charging-discharging system and a method for diagnosing faulty wiring for the charging-discharging system are provided according to embodiments of the present disclosure. The charging-discharging system can diagnose faulty wiring between a combiner box and itself after being powered on.

The technical solutions according to the embodiments are described below for the above purpose.

In a first aspect, a method for diagnosing faulty wiring for a charging-discharging system is provided. The charging-discharging system includes at least two charging-discharging devices each have a port connected to a corresponding sub-interface of a combiner box. The method includes: switching on a master switch in the charging-discharging device after being powered on; determining whether an absolute value of voltage across the master switch is greater than a first preset voltage; and determining that the faulty wiring is between the charging-discharging device and the corresponding sub-interface of the combiner box, if determined that the absolute value is greater than the first preset voltage.

Preferably, the method further includes: determining whether the master switch is already on, after the switching on the master switch, where whether the absolute value is greater than the first preset voltage is determined if the master switch is already on.

Preferably, the determining whether the master switch is already on includes: determining whether a feedback signal is received, where the feedback signal is uploaded by the master switch when switched on; and determining that the master switches is already on, on receipt of the feedback signal.

Preferably, the determining whether the master switch is already on includes: determining whether a voltage at the port of the charging-discharging device is greater than or equal to a second preset voltage; and determining that the master switch is already on, if determined that the voltage is greater than or equal to the second preset voltage.

Preferably, the second preset voltage is equal to a floating voltage at the port of the charging-discharging device.

Preferably, the method further includes: determining whether the absolute value is greater than the first preset voltage throughout a first preset period of time before the determining that the faulty wiring is between the charging-discharging device and the corresponding sub-interface. It is determined that the faulty wiring is between the charging-discharging device and the corresponding sub-interface, if determined that the absolute value is greater than the first preset voltage throughout the first preset period of time.

Preferably, the first preset voltage is equal to a voltage sampling size of the charging-discharging device.

Preferably, the method further includes: reporting a diagnosis result for the charging-discharging system, after the determining that the faulty wiring is between the charging-discharging device and the corresponding sub-interface.

Preferably, the method further includes: determining whether an actual operating mode of a target charging-discharging device is consistent with a set operating mode, while the at least charging-discharging devices are operating, where the target charging-discharging device is one of the operating charging-discharging devices; and determining that the faulty wiring is between the target charging-discharging device and the corresponding sub-interface, if determined that the actual operating mode is not consistent with the set operating mode.

Preferably, the determining whether the actual operating mode of the target charging-discharging device is consistent with the set operating mode includes: determining whether a set operating current of the target charging-discharging device is greater than or equal to a first preset current; determining whether a sampled operating current of the target charging-discharging device is less than or equal to a second preset current, if determined that the set operating current is greater than or equal to the first preset current; and determining that the actual operating mode is not consistent with the set operating mode, if determined that the sampled operating current is less than or equal to the second preset current.

Preferably, the method further includes: determining whether the set operating current is greater than or equal to the first preset current throughout a second preset period of time, before the determining whether the sampled operating current is less than or equal to the second preset current, where whether the sampled operating current is less than or equal to the second preset current is determined if determined that the set operating current is greater than or equal to the first preset current throughout the second preset period of time.

Preferably, the first preset current depends on a maximum operating current that the charging-discharging device withstands.

Preferably, the second preset current depends on a current sampling size of the charging-discharging device.

Preferably, the method further includes: determining whether the master switch in the target charging-discharging device is on, before the determining whether the set operating current is greater than or equal to the first preset current, where whether the set operating current is greater than or equal to the first preset current is determined if determined that the master switch in the target charging-discharging device is already on.

Preferably, the method further includes: reporting a diagnosis result and a serial number of the target charging-discharging device, after the determining that the faulty wiring is between the target charging-discharging device and the corresponding sub-interface.

In another aspect, a charging-discharging system is provided in the present disclosure. The charging-discharging system includes a first controller and at least two charging-discharging devices. The first controller is communicatively connected with each of the charging-discharging devices. The first controller is configured to perform the method as described above.

Preferably, each of the charging-discharging devices includes a second controller, a charging-discharging unit, a master switch, a pre-charging branch, and a protection switch. A port of the charging-discharging unit is connected to a port of the charging-discharging device via the protection switch and the master switch sequentially. The pre-charging branch is connected in parallel with the master switch. The charging-discharging unit, the pre-charging branch, the master switch, and the protection switch are controlled by the second controller. The second controller is configured to monitor an operating state of the charging-discharging device. The second controller is communicatively connected with the first controller.

Preferably, all the second controllers and the first controller are integrated into a system controller.

Preferably, the charging-discharging unit is a power generation unit or an energy storage unit. Alternatively, the charging-discharging unit includes a power generation unit and an energy storage unit.

Preferably, the power generation unit is configured to generate power from renewable sources.

According to the above technical solutions, the method for diagnosing faulty wiring for a charging-discharging system is provided in the present disclosure. In the method, if there is no faulty wiring between the charging-discharging devices and the corresponding sub-interfaces of the combiner box, a voltage across the master switch of each charging-discharging device is approximately zero after the charging-discharging devices are all powered on and the master switch in one of the charging-discharging devices is on. That is, the absolute value of the voltage across the master switch is less than or equal to the first preset voltage. Therefore, where there is a master switch whose voltage has the absolute value greater than the first preset voltage, there is faulty wiring between the charging-discharging device where the master switch is arranged and the corresponding sub-interface of the combiner box. That is, there is faulty wiring between the charging-discharging system and the combiner box. In addition, the charging-discharging system may be a household energy storage system and the charging-discharging device may be a battery system. Therefore, with the method, the household energy storage system can diagnose faulty wiring between a combiner box and itself after powered on.

### BRIEF DESCRIPTION OF THE DRAWINGS

For clearer illustration of the technical solutions according to embodiments of the present disclosure or conventional techniques, hereinafter briefly described are the drawings to be applied in embodiments of the present disclosure or conventional techniques. Apparently, the drawings in the following descriptions show only some embodiments of the present disclosure, and other drawings may be obtained by those skilled in the art based on the provided drawings without creative efforts.
Figure 1 to Figure 8 are flowcharts each showing a method for diagnosing faulty wiring for a charging-discharging system according to an embodiment of the present disclosure;
Figure 9 to Figure 11 are flowcharts each showing determination of whether an actual operating mode of a target charging-discharging device is consistent with a set operating mode according to an embodiment of the present disclosure;
Figure 12 is a schematic structural diagram of a charging-discharging system according to an embodiment of the present disclosure; and
Figure 13 is a schematic structural diagram of a charging-discharging device according to an embodiment of the present disclosure.

### DETAILED DESCRIPTION

Hereinafter, technical solutions of embodiments of the present disclosure are described clearly and completely in conjunction with the drawings of the embodiments of the present disclosure. Apparently, the embodiments described below are only some rather than all the embodiments of the present disclosure. Any other embodiments obtained by those skilled in the art based on the embodiments in the present disclosure without any creative effort shall fall within the protection scope of the present disclosure.

In the present disclosure, the relationship terminologies such as "first" and "second" are only used to distinguish one entity or operation from another, rather than to necessitate or imply that the actual relationship or order exists between the entities or operations. Moreover, terms "include", "comprise" or any other variants are intended to be non-exclusive. Therefore, a process, method, article or device including a series of elements includes not only the elements but also other elements that are not enumerated, or further includes the elements inherent in the process, method, article or device. Unless expressively limited otherwise, the statement "comprising (including) one..." does not exclude existence of other similar elements in the process, method, article or device.

A method for diagnosing faulty wiring for a charging-discharging system is provided in the present disclosure, to diagnose faulty wiring between a battery system and a corresponding interface of a combiner box. The charging-discharging system includes at least two charging-discharging devices each have ports connected to a corresponding sub-interface of the combiner box via power cables. Thereby, the charging-discharging devices are connected in parallel.

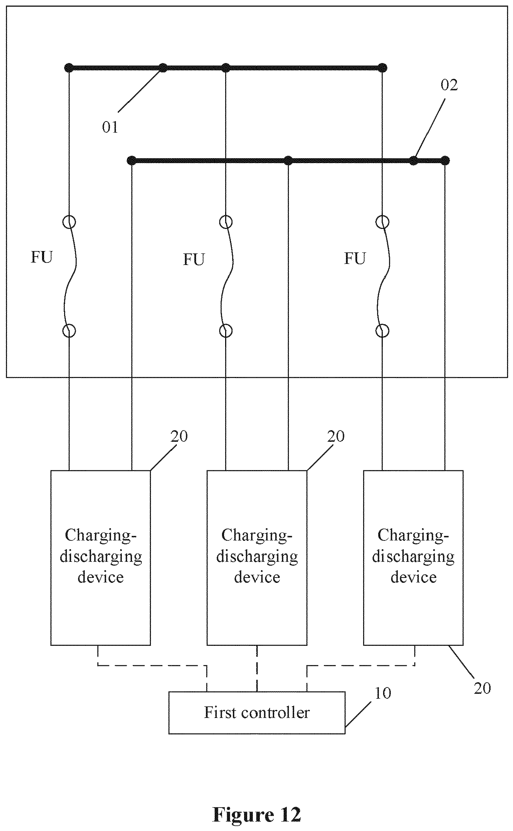

In practice, the combiner box, as shown in Figure 12, includes a positive bus O1, a negative bus 02 and at least two fuses FU (e.g., three fuses FU as shown in Figure 12). The positive bus 01 is connected to positive terminals of sub-interfaces of the combiner box. The negative bus 02 is connected to negative terminals of sub-interfaces of the combiner box. The positive bus 01 is further connected to a positive terminal of a general interface of the combiner box. The negative bus 02 is further connected to a negative terminal of the general interface of the combiner box. Typically, the general interface of the combiner box is connected to a power conversion system (PCS) or other power converters. The fuse FU is arranged between the positive bus 01 and the positive terminal of a corresponding sub-interface of the combiner box, or between the negative bus 02 and the negative terminal of the corresponding sub-interface of the combiner box.

It should be noted that in practice, in addition to the above-mentioned components, the combiner box further includes other components, which are not specifically limited herein and depend on specific circumstances, and are all within the protection scope of the present disclosure. In addition, other details about the combiner box are the same as the conventional technology, and are not described herein.

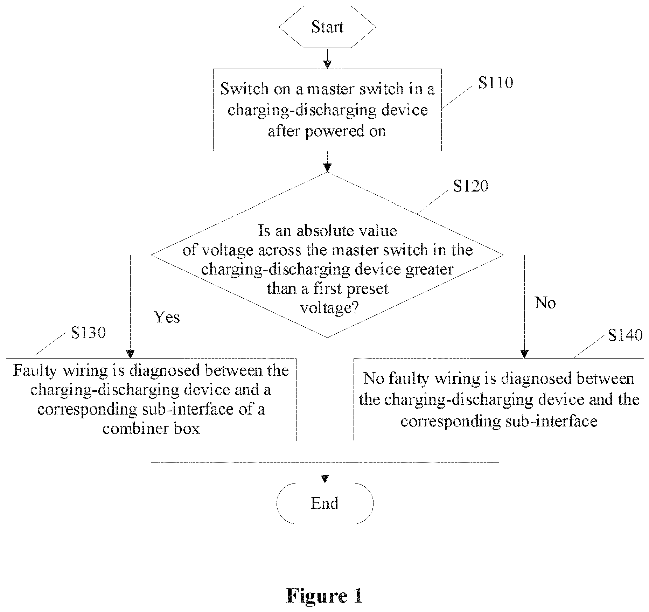

Figure 1 shows a flowchart of the method for diagnosing faulty wiring for the charging-discharging system according to an embodiment of the present disclosure. The method includes the following steps S110 to S140.

In S 110, for each of the at least two charging-discharging devices, a master switch in the charging-discharging device is switched on, after the charging-discharging devices are all powered on.

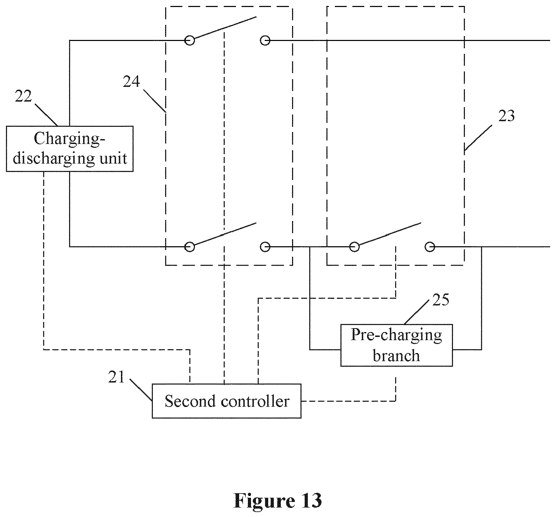

In practice, as shown in Figure 13, each charging-discharging device includes a charging-discharging unit, a master switch and a protection switch, which are connected as follows. A port of the charging-discharging unit is connected to a port of the charging-discharging device via the protection switch and the master switch sequentially. The protection switch is configured to switch off in response to an excessive charging or discharging current through the charging-discharging device, to protect the charging-discharging device from damages. The master switch is configured to control connection between the charging-discharging device and the corresponding sub-interface of the combiner box.

In practice, when the protection switch is on and the master switch is off, the charging-discharging device is powered on. In this case, the charging-discharging device is not connected to the sub-interface of the combiner box, that is, a voltage is applied to the port of the charging-discharging unit, and no voltage is applied between the positive bus 01 and the negative bus 02 in the combiner box. In a case that the protection switch and the master switch are both on, the charging-discharging device operates. In this case, the charging-discharging device is powered on and is connected to the corresponding sub-interface of the combiner box, that is, a voltage is applied on the port of the charging-discharging unit, and a voltage is also applied between the positive bus 01 and the negative bus 02 in the combiner box.

In S120, it is determined whether an absolute value of voltage across the master switch in the charging-discharging device is greater than a first preset voltage.

The method proceeds to S130 if the absolute value is greater than the first preset voltage. The method proceeds to S140 if the absolute value is less than or equal to the first preset voltage.

In practice, the charging-discharging device further includes a controller. The controller is configured to monitor an operating mode of the charging-discharging device, i.e., the voltage across the master switch. Therefore, the voltage across the master switch is obtained in S120 through communications with the controller in the charging-discharging device.

The first preset voltage may be equal to zero, or a voltage sampling size of the controller in the charging-discharging device, e.g., 3V. The first preset voltage is not specifically limited herein, and all are within the protection scope of the present disclosure. The former case (equal to zero) is applicable to only an ideal situation. The latter case (equal to the sampling size) is applicable to practice and therefore is preferable to the present disclosure. In addition, the first preset voltage being set to the sampling size can avoid mis-determination in S120, and thereby improving determination accuracy of the method.

In S130, there is faulty wiring between the charging-discharging device and the corresponding sub-interface of the combiner box.

In S140, there is no faulty wiring between the charging-discharging device and the corresponding sub-interface of the combiner box.

In other words, it is determined in S130 that there is faulty wiring between the charging-discharging system and the combiner box. It is determined in S140 that there is no faulty wiring between the charging-discharging system and the combiner box.

As can be seen from the above, in a case that there is no faulty wiring between the charging-discharging devices and the corresponding sub-interfaces of the combiner box (where each of the charging-discharging devices is electrically connected to a corresponding sub-interface of the combiner box), that is, after the charging-discharging devices are all powered on and the master switch in one of the charging-discharging devices is switched on, (that is, after a voltage is applied between the positive bus 01 and the negative bus 02 in the combiner box), a voltage is applied to the port of each of the charging-discharging devices. The voltage is theoretically equal to the voltage of the port of the charging-discharging unit. That is, for each of the charging-discharging devices, the absolute value of voltage across the master switch in the charging-discharging device is less than or equal to the first preset voltage. Therefore, where there is a charging-discharging device whose master switch bears a voltage difference greater than the first preset voltage, there is faulty wiring between the charging-discharging device and the corresponding sub-interface of the combiner box. That is, there is faulty wiring between the charging-discharging system and the combiner box. In addition, the charging-discharging system may be a household energy storage system and the charging-discharging device may be a battery system. Therefore, with the method, the household energy storage system can diagnose faulty wiring between a combiner box and itself after powered on.

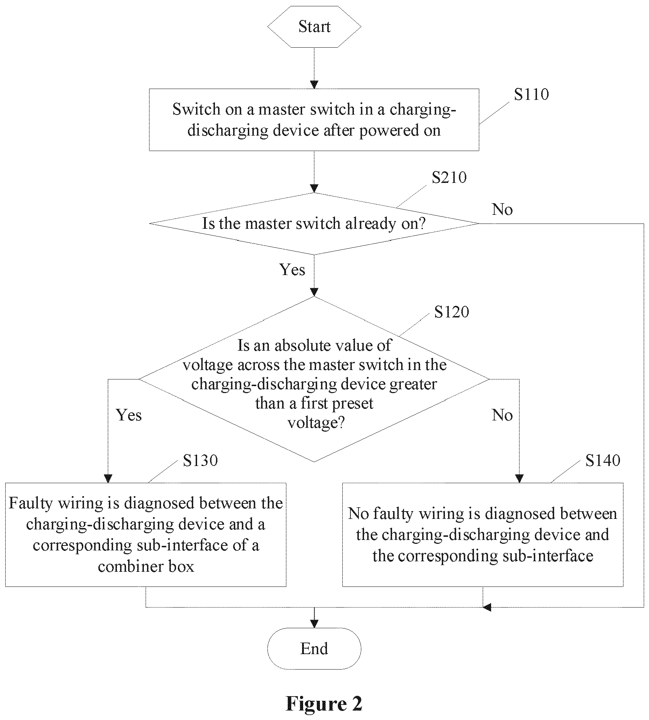

Figure 2 shows a flowchart of the method according to another embodiment of the present disclosure. As shown in Figure 2, the method further includes S210 after S110 based on the embodiment as shown in Figure 1.

In S210, it is determined whether the master switch is already on.

The method proceeds to S120 if determined that the master switch is already is on. The method terminates if no master switch is on.

Here, S210 is added so that S120 is performed only when at least one master switch is on. Thereby, mis-determination can be avoided.

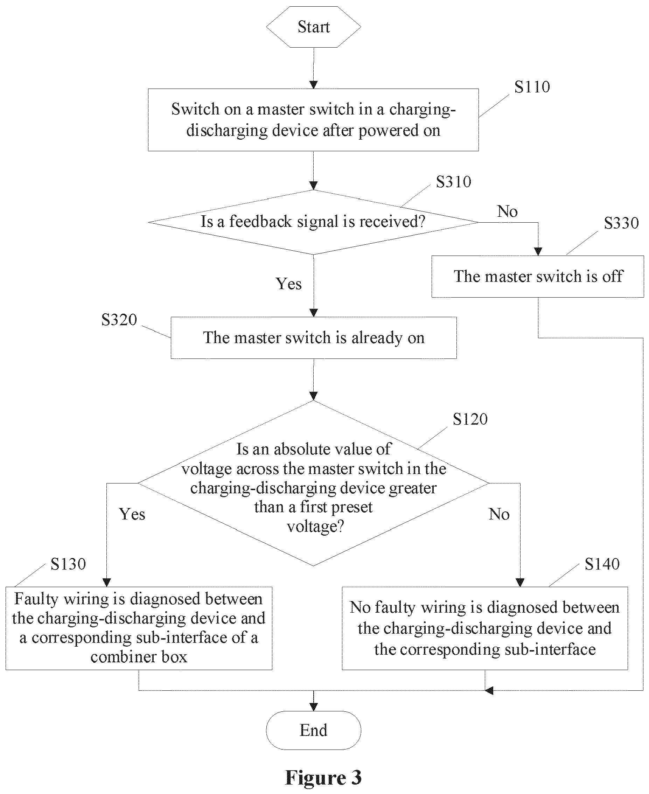

S210 is further applicable to a situation where the master switch uploads a feedback signal after switched on. As shown in Figure 3, 5210 includes the following steps S310 to S330 in this situation.

In S310, it is determined whether a feedback signal is received.

The method proceeds to S320 on receipt of the feedback signal. The method proceeds to S330 in case of no feedback signal.

The feedback signal is uploaded to the controller in the charging-discharging device by the master switch in the charging-discharging device after switched on, indicating that the master switch is successfully switched on.

In S320, it is determined that the master switch is already on.

In S330, it is determined that the master switch is off.

Whether there is a master switch is already on can be determined by detecting whether a feedback signal is received. Thereby, a possibility of mis-determination can be reduced.

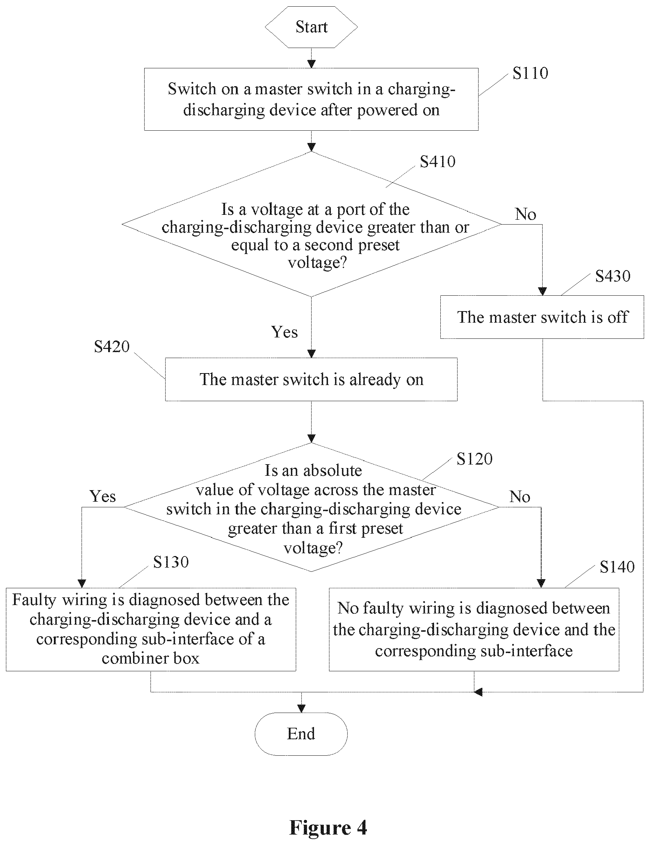

In practice, the master switch that is not actually on may upload a feedback signal in error due to it malfunction. In order to avoid such situation, S210 includes the following steps S410 to S430, as shown in Figure 4.

In S410, it is determined whether a voltage at the port of the charging-discharging device is greater than or equal to a second preset voltage.

The method proceeds to S420 if the voltage is greater than or equal to the second preset voltage. The method proceeds to S430 if the voltage is less than the second preset voltage.

Before S410, the voltage at the port of each charging-discharging device is obtained through communications with the controller in the charging-discharging device.

In practice, the second preset voltage may be equal to zero, or a floating voltage of at the port of the charging-discharging device. The former case (equal to zero) is applicable to a situation where no floating voltage is applied to the port of the charging-discharging device. The latter case (equal to the floating voltage) is applicable to a situation where a floating voltage is applied to the port of the charging-discharging device. Details about the second preset voltage is not limited herein but depend on specific situations.

In practice, the floating voltage is proportional to the voltage at the port of the charging-discharging device. Normally, the floating voltage is equal to three-tenths or two-fifths of the voltage at the port of the charging-discharging device.

In S420, it is determined that the master switch is already on.

In S430, it is determined that the master switch is off.

Here, it is determined in S210 whether the master switch is already on by comparing the voltage at the port of the charging-discharging device with the second preset voltage. Therefore, mis-determination can be further avoided even if the master switch that is not on uploads the feedback signal in error, by comparison with the above embodiment. Hence, the possibility of mis-determination can be further reduced.

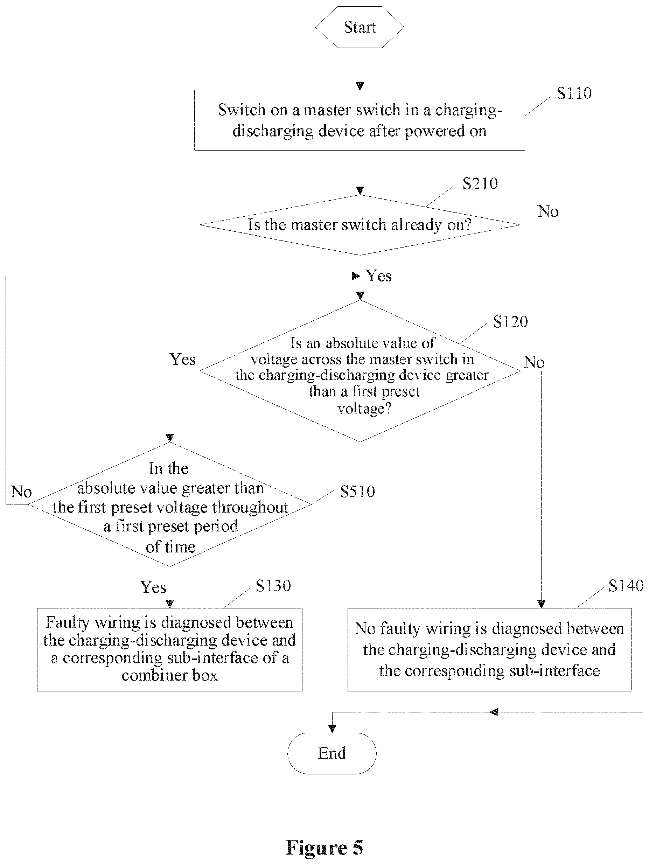

Figure 5 shows a flowchart of the method according to another embodiment of the present disclosure. Figure 5 is illustrated on the basis of Figure 2. As shown in Figure 5, the method further includes S510 before S130.

In S510, it is determined whether the absolute value is greater than the first preset voltage throughout a first preset period of time.

The method proceeds to S130 if the absolute value is greater than the first preset voltage throughout the first preset period of time. The method returns to S120 if the absolute value is not greater than the first preset voltage throughout the first preset period of time.

The first preset period of time is set depending on actual situations. Generally, the first preset time period may be set to 3 seconds.

Here, S510 is added to the method, so that mis-determination can be successfully avoided even if mis-determination occurs in S120. Therefore, the accuracy of the method is further improved.

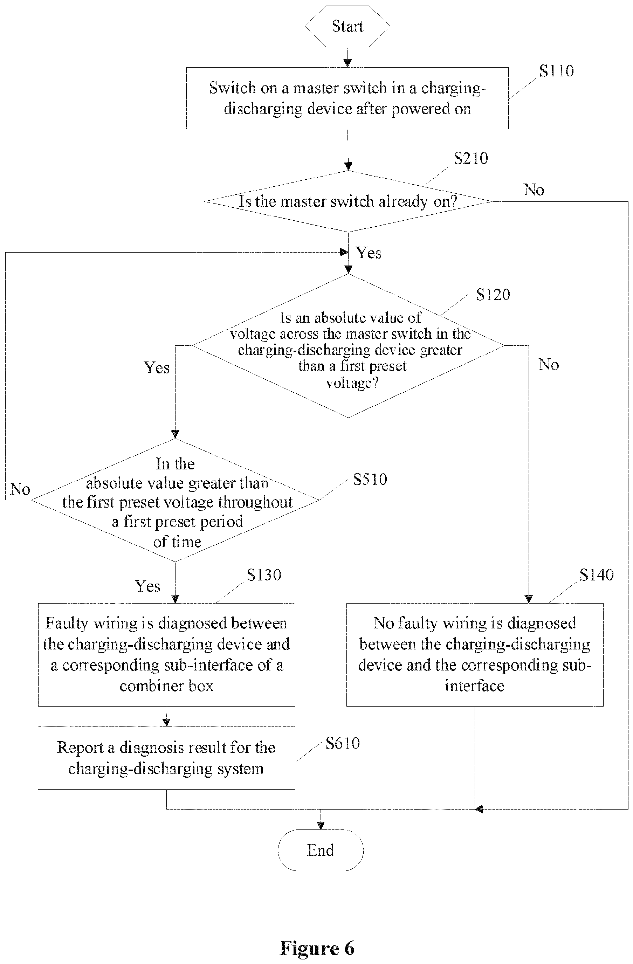

Figure 6 shows a flowchart of the method according to another embodiment of the present disclosure. As shown in Figure 6, the method further includes S610 after S130 based on the embodiment as shown in Figure 5.

In S610, a diagnosis result for the charging-discharging system is reported.

In practice, the diagnosis result may be reported to a cloud platform or other superior systems, depending on specific situations. All alternatives fall within the protection scope of the present disclosure.

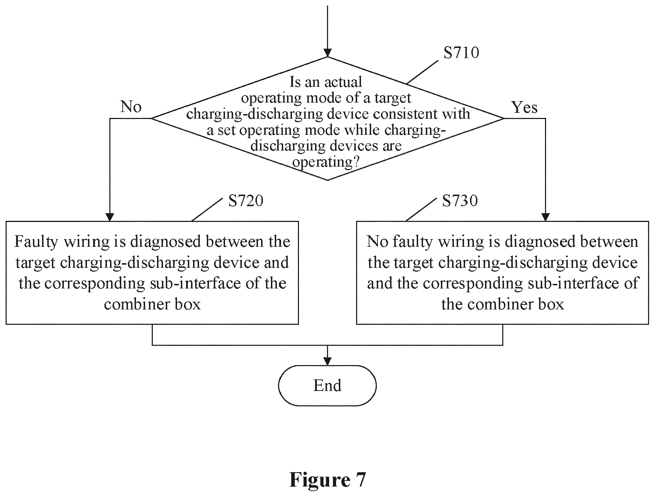

Figure 7 shows a flowchart of the method according to another embodiment of the present disclosure. As shown in Figure 7, the method further includes S710 to S730 based on the embodiment as shown in Figure 6.

In S710, it is determined whether an actual operating mode of a target charging-discharging device is consistent with a set operating mode, while the at least two charging-discharging devices are operating.

The method proceeds to S720 if the actual operating mode is not consistent with the set operating mode. The method proceeds to S730 if the actual operating mode is consistent with the set operating mode.

It should be noted that, the condition under which the charging-discharging device operates is described in detail in the above embodiments, and is therefore not repeated here. The charging-discharging system starts to operate normally when at least two charging-discharging devices are operating.

The target charging-discharging device refers to the charging-discharging device that is in operation. The charging-discharging device is currently operating in the actual operating mode. The controller in the charging-discharging system presets the charging-discharging device to operate in the set operating mode.

In S720, the faulty wiring is diagnosed between the target charging-discharging device and the corresponding sub-interface of the combiner box.

In S730, no faulty wiring is diagnosed between the target charging-discharging device and the corresponding sub-interface of the combiner box.

In practice, in case of no faulty wiring between the target charging-discharging device and the corresponding sub-interface of the combiner box, the actual operating mode of the target charging-discharging device is consistent with the set operating mode. Therefore, in a case that the actual operating mode of the target charging-discharging device is not consistent with the set operating mode, there is faulty wiring between the target charging-discharging device and the corresponding sub-interface of the combiner box. In this way, the diagnosed faulty wiring can be accurately directed to a charging-discharging device between its corresponding sub-interface while the charging-discharging system is operating.

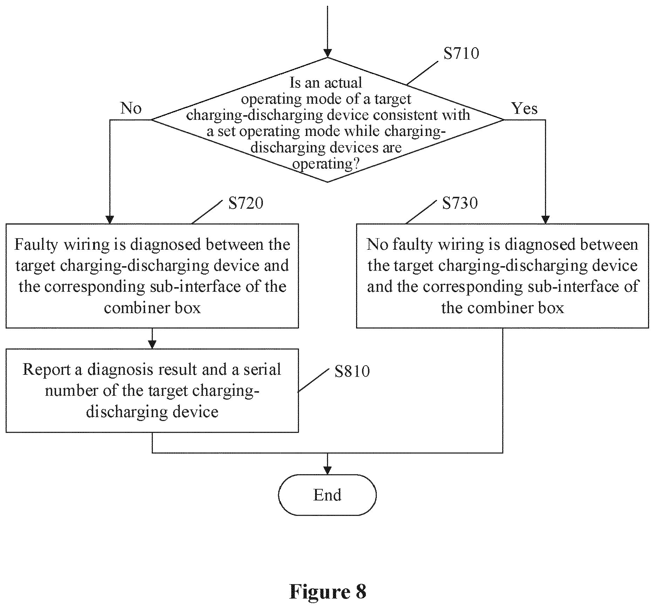

Figure 8 shows a flowchart of the method according to another embodiment of the present disclosure. As shown in Figure 8, the method further includes S810 after S720 based on the embodiment as shown in Figure 7.

In S810, a diagnosis result and a serial number of the target charging-discharging device is reported.

In practice, the diagnosis result may be reported to a cloud platform or other superior systems, depending on specific situations. All alternatives fall within the protection scope of the present disclosure.

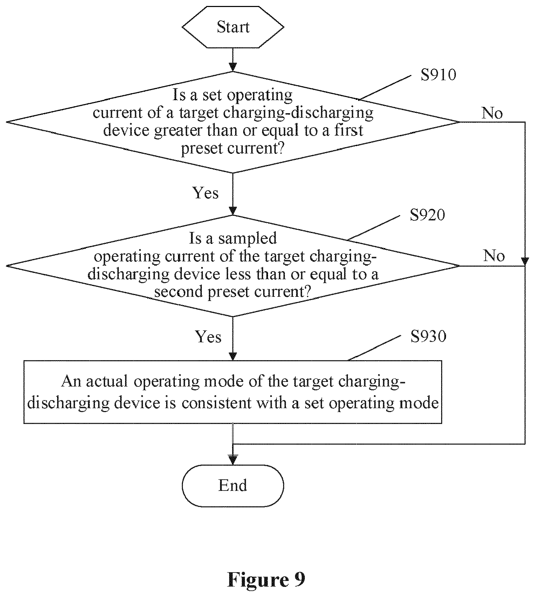

Figure 9 shows the determination of whether the actual operating mode is consistent with the set operating mode according to an embodiment of the present disclosure. As shown in Figure 9, the determination includes S910 to 5930.

In S910, it is determined whether a set operating current of the target charging-discharging device is greater than or equal to a first preset current.

The method proceeds to S920 if determined that the set operating current is greater than or equal to the first preset current. The method terminates if determined that the set operating current is less than the first preset current.

In a case that the set operating current of the target charging-discharging device is greater than or equal to the first preset current, the charging-discharging device is operating normally under control of the controller in the charging-discharging system. The first preset current depends on a maximum operating current that the charging-discharging device withstands and is usually set to 3A.

In S920, it is determined whether a sampled operating current of the target charging-discharging device is less than or equal to a second preset current.

The method proceeds to S930 if determined that the sampled operating current is less than or equal to the second preset current. The method terminates if determined that the sampled operating current of the target charging-discharging device is greater than the second preset current.

In a case that the sampled operating current of the target charging-discharging device is less than or equal to the second preset current, the charging-discharging device in the charging-discharging system fails to operate normally. The second preset current depends on a current sampling size of the charging-discharging device and is usually set to 0.5A.

In S930, it is determined that the actual operating mode is consistent with the set operating mode.

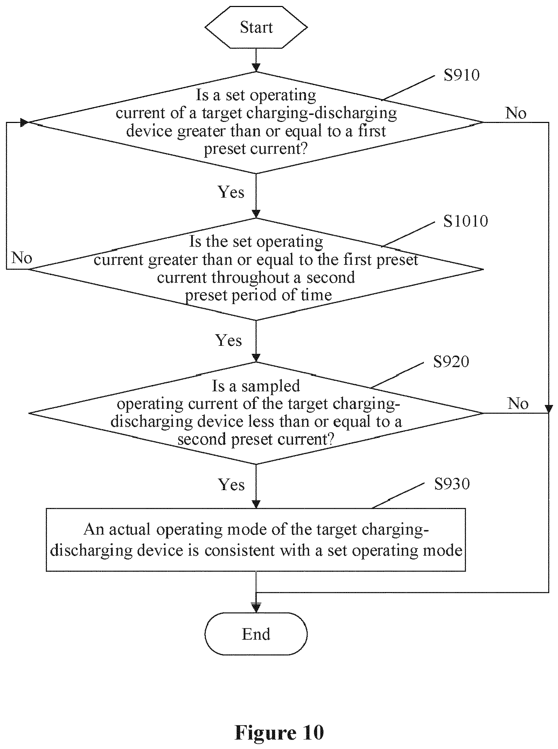

Figure 10 shows the determination of whether the actual operating mode is consistent to the set operating mode according to another embodiment of the present disclosure. As shown in Figure 10, the determination further includes S1010 before S920 based on the embodiment as shown in Figure 9.

In S1010, it is determined whether the set operating current of the target charging-discharging device is greater than or equal to the first preset current throughout a second preset period of time.

The method proceeds to S920 if the set operating current is greater than or equal to the first preset current throughout the second preset period of time. The method proceeds to S910 if the set operating current is not greater than or equal to the first preset current throughout a second preset period of time.

The second preset period of time depends on actual situations. Generally, the second preset time period may be set to 30 minutes.

Here, S1010 is added to the method, so that mis-determination can be successfully avoided even if mis-determination occurs in S910. Therefore, the accuracy of the method is further improved.

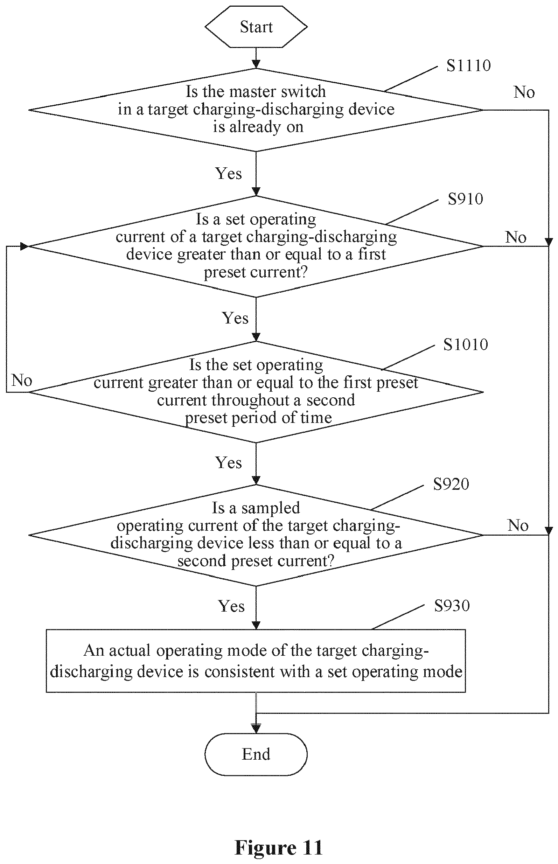

Figure 11 shows the determination of whether the actual operating mode is consistent to the set operating mode according to another embodiment of the present disclosure. As shown in Figure 11, the determination further includes S 1110 before S910 based on the embodiment as shown in Figure 10.

In S1110, it is determined whether the master switch in the target charging-discharging device is on.

The method proceeds to S910 if the master switch in the target charging-discharging device is on. The method terminates if the master switch in the target charging-discharging device is not on.

Here, S1110 is added so that S910 is performed only when the master switch in target charging-discharging device is on. Thereby, mis-determination can be successfully avoided.

A charging-discharging system is further provided according to embodiments of the present disclosure. As shown in Figure 12, the charging-discharging system includes a first controller and at least two charging-discharging devices (e.g., exactly two charging-discharging devices as shown in Figure 12), which are connected as follows.

The charging-discharging devices each have ports connected to a corresponding sub-interface of a combiner box through power cables. Thereby, the charging-discharging devices are connected in parallel.

The first controller is communicatively connected to each of the charging-discharging devices. The first controller is configured to perform the method according to the above embodiments.

Figure 13 is a schematic structural diagram of the charging-discharging device according to an embodiment of the present disclosure. As shown in Figure 13, the charging-discharging device includes a second controller 21, a charging-discharging unit 22, a master switch 23, a protection switch 24 and a pre-charging branch 25, which are connected as follows.

A port of the charging-discharging unit 22 is connected to the port of the charging-discharging device via the protection switch 24 and the master switch 23 sequentially. The pre-charging branch 25 is connected in parallel with the master switch 23. The charging-discharging unit 22, the pre-charging branch 25, the master switch 23 and the protection switch 24 are controlled by the second controller 21. The second controller 21 is configured to monitor an operating mode of the charging-discharging device. The second controller 21 is communicatively connected to the first controller.

In practice, second controllers 21 of all the charging-discharging devices may be integrated with the first controller to form a system controller, which is included but not limited in practice, depends on specific situations, and all fall within the protection scope of the present disclosure.

In practice, the charging-discharging unit 22 is a power generation unit or an energy storage unit. Alternatively, the charging-discharging unit 22 includes a power generation unit and an energy storage unit, which is not specifically limited herein but depends on specific situations, and all fall within the protection scope of the present disclosure.

The power generation unit preferably generates power from renewable sources, which is included but not limited in practice and depends on specific situations, and all fall within the protection scope of the present disclosure.

For the above description of the disclosed embodiments, the features recorded in the embodiments in this specification may be replaced or combined with each other so that those skilled in the art can implement or use the present disclosure. The above description illustrates only preferred embodiments of the present disclosure, rather than limits the present disclosure in any form. Although the present disclosure has been disclosed above with the preferred embodiments, it is not intended to limit the present disclosure to those embodiments. Various possible changes and modifications to the technical solution of the present disclosure, or equivalents of the embodiments, can be made by those skilled in the art based on the method and technical content disclosed above without departing from the scope of the technical solution of the present disclosure. Therefore, any simple modifications, equivalent changes, and modifications made to the above embodiments based on the technical essence of the present disclosure without departing from the content of the technical solution of the present disclosure still fall within the protection scope of the technical solution of the present disclosure.

## Claims

1. A method for diagnosing faulty wiring for a charging-discharging system, wherein the charging-discharging system comprises at least two charging-discharging devices each have a port connected to a corresponding sub-interface of a combiner box, and the method comprises: for each of the at least two charging-discharging devices,
switching on a master switch in the charging-discharging device after being powered on;
determining whether an absolute value of voltage across the master switch is greater than a first preset voltage; and
determining that the faulty wiring is between the charging-discharging device and the corresponding sub-interface of the combiner box, if determined that the absolute value is greater than the first preset voltage.

2. The method according to claim 1, further comprising:
determining whether the master switch is already on, after the switching on the master switch, wherein whether the absolute value is greater than the first preset voltage is determined if the master switch is already on.

3. The method according to claim 2, wherein the determining whether the master switch is already on comprises:
determining whether a feedback signal is received, wherein the feedback signal is uploaded by the master switch when switched on; and
determining that the master switches is already on, on receipt of the feedback signal.

4. The method according to claim 2, wherein the determining whether the master switch is already on comprises:
determining whether a voltage at the port of the charging-discharging device is greater than or equal to a second preset voltage; and
determining that the master switch is already on, if determined that the voltage is greater than or equal to the second preset voltage.

5. The method according to claim 1, further comprising:
determining whether the absolute value is greater than the first preset voltage throughout a first preset period of time before the determining that the faulty wiring is between the charging-discharging device and the corresponding sub-interface, wherein it is determined that the faulty wiring is between the charging-discharging device and the corresponding sub-interface, if determined that the absolute value is greater than the first preset voltage throughout the first preset period of time.

6. The method according to claim 1, further comprising:
reporting a diagnosis result for the charging-discharging system, after the determining that the faulty wiring is between the charging-discharging device and the corresponding sub-interface.

7. The method according to any one of claims 1 to 6, further comprising:
determining whether an actual operating mode of a target charging-discharging device is consistent with a set operating mode, while the at least charging-discharging devices are operating, wherein the target charging-discharging device is one of the operating charging-discharging devices; and
determining that the faulty wiring is between the target charging-discharging device and the corresponding sub-interface, if determined that the actual operating mode is not consistent with the set operating mode.

8. The method according to claim 7, wherein the determining whether the actual operating mode of the target charging-discharging device is consistent with the set operating mode comprises:
determining whether a set operating current of the target charging-discharging device is greater than or equal to a first preset current;
determining whether a sampled operating current of the target charging-discharging device is less than or equal to a second preset current, if determined that the set operating current is greater than or equal to the first preset current; and
determining that the actual operating mode is not consistent with the set operating mode, if determined that the sampled operating current is less than or equal to the second preset current.

9. The method according to claim 8, further comprising:
determining whether the set operating current is greater than or equal to the first preset current throughout a second preset period of time, before the determining whether the sampled operating current is less than or equal to the second preset current, wherein whether the sampled operating current is less than or equal to the second preset current is determined if determined that the set operating current is greater than or equal to the first preset current throughout the second preset period of time.

10. The method according to claim 8, further comprising:
determining whether the master switch in the target charging-discharging device is on, before the determining whether the set operating current is greater than or equal to the first preset current, wherein whether the set operating current is greater than or equal to the first preset current is determined if determined that the master switch in the target charging-discharging device is already on.

11. The method according to claim 7, further comprising:
reporting a diagnosis result and a serial number of the target charging-discharging device, after the determining that the faulty wiring is between the target charging-discharging device and the corresponding sub-interface.

12. A charging-discharging system, comprising:
a first controller; and
at least two charging-discharging devices, wherein
the first controller is communicatively connected with each of the charging-discharging devices, and
the first controller is configured to perform the method according to any one of claims 1 to 11.

13. The charging-discharging system according to claim 12, wherein each of the charging-discharging devices comprises:
a second controller;
a charging-discharging unit;
a master switch;
a pre-charging branch; and
a protection switch, wherein
a port of the charging-discharging unit is connected to a port of the charging-discharging device via the protection switch and the master switch sequentially;
the pre-charging branch is connected in parallel with the master switch;
the second controller is configured to control the charging-discharging unit, the pre-charging branch, the master switch, and the protection switch;
the second controller is configured to monitor an operating mode of the charging-discharging device, and
the second controller is communicatively connected with the first controller.

14. The charging-discharging system according to claim 13, wherein
all the the second controllers and the first controller are integrated into a system controller.

15. The charging-discharging system according to claim 13, wherein
the charging-discharging unit is a power generation unit or an energy storage unit; or
the charging-discharging unit comprises a power generation unit and an energy storage unit.
